# EUROPÄISCHE PATENTSCHRIFT

(11) **EP 3 378 105 B1**
(45) Veröffentlichungstag und Bekanntmachung des Hinweises auf die Patenterteilung: **26.08.2020**
(21) Anmeldenummer: 16801411.6
(22) Anmeldetag: 17.11.2016
(51) Int. Cl.: H01L 33/08, H01L 33/50, H01L 25/075

(54) **HALBLEITERBAUELEMENT**
SEMICONDUCTOR DEVICE
DISPOSITIF SEMICONDUCTEUR

(30) Priorität: 17.11.2015 DE 102015119817
(43) Veröffentlichungstag der Anmeldung: 26.09.2018
(73) Patentinhaber: OSRAM Opto Semiconductors GmbH, 93055 Regensburg (DE)
(72) Erfinder: PUST, Philipp, 84085 Langquaid (DE); RACZ, David, 93051 Regensburg (DE); KÖLPER, Christopher, 93049 Regensburg (DE)
(74) Vertreter: Epping - Hermann - Fischer
(86) Internationale Anmeldenummer: PCT/EP2016/078047
(87) Internationale Veröffentlichungsnummer: WO 2017/085207

(56) Entgegenhaltungen:
- DE-A1-102013 112 740
- US-A1- 2005 230 693
- US-A1- 2007 045 609
- US-A1- 2009 153 024
- US-A1- 2010 155 694
- US-A1- 2015 123 153
- US-A1- 2015 129 916
- PHILIPP PUST ET AL: "Narrow-band red-emitting Sr[LiAl3N4]:Eu2+ as a next-generation LED-phosphor material", NATURE MATERIALS, Bd. 13, Nr. 9, 22. Juni 2014 (2014-06-22), Seiten 891-896, XP055183343, ISSN: 1476-1122, DOI: 10.1038/nmat4012
- JINN-KONG SHEU ET AL: "GaN-based photon-recycling green light-emitting diodes with vertical-conduction structure", OPTICS EXPRESS, Bd. 23, Nr. 7, 20. März 2015 (2015-03-20), Seite A371, XP055337846, DOI: 10.1364/OE.23.00A371

## Beschreibung

Die vorliegende Anmeldung betrifft ein Halbleiterbauelement mit einem Halbleiterchip zur Erzeugung einer elektromagnetischen Primärstrahlung. Die Erfindung wird durch den angehängten Satz von Ansprüchen definiert. Ausführungsbeispiele in der Beschreibung, die nicht in den Rahmen dieser Ansprüche fallen sind als Vergleichsbeispiele zu betrachten.

Für die Hinterleuchtung von Anzeigevorrichtung, beispielsweise Flüssigkristalldisplays (LCDs), können Leuchtdioden als Strahlungsquellen eingesetzt werden. Solche Anwendungen erfordern jedoch einen hohen Gamut, um einen möglichst großen Anteil der vom menschlichen Auge wahrnehmbaren Farben darstellen zu können. Beispielsweise kann durch LEDs, die im blauen Spektralbereich emittieren und einen im gelben Spektralbereich emittierenden Leuchtstoff für das menschliche Auge weiß erscheinende Strahlung zwar mit hoher Effizienz, aber mit reduziertem Gamut erzeugt werden. Durch Zugabe weiterer Leuchtstoffe kann der Gamut verbessert werden, die Effizienz nimmt jedoch ab. Ein hoher Farbgamut kann weiterhin erzielt werden, wenn drei voneinander verschiedene Leuchtdioden direkt Strahlung im roten, grünen und blauen Spektralbereich erzeugen. Dies erfordert jedoch aufgrund der Ansteuerung von drei Leuchtdioden eine komplexe elektronische Steuerung.

Die Dokumente US2009/0153024-A1, US2015/0123153-A1, US2010/0155694-A1 und US2015/0129916-A1 offenbaren verschiedene Licht emittierende Halbleiterbauelemente gemäß des Stands der Technik.

Eine Aufgabe ist es, ein Halbleiterbauelement anzugeben, mit dem eine Mischstrahlung mit hoher Effizienz erzielt werden kann.

Diese Aufgabe wird durch das vorgeschlagene Halbleiterbauelement gelöst. Weitere Ausgestaltungen und Zweckmäßigkeiten sind Gegenstand der abhängigen Ansprüche.

Das Halbleiterbauelement weist einen oder mehrere Halbleiterchips zur Erzeugung einer elektromagnetischen Primärstrahlung mit einer ersten Peakwellenlänge auf. Zudem ist zumindest ein erstes Konversionselement mit einer Quantenstruktur vorgesehen, wobei die Quantenstruktur ausgebildet ist, um die Primärstrahlung wenigstens teilweise in eine Sekundärstrahlung mit einer zweiten Peakwellenlänge zu verschieben. Weiterhin ist zumindest ein zweites Konversionselement vorgesehen ist, das einen Leuchtstoff aufweist, wobei der Leuchtstoff ausgebildet ist, um eine elektromagnetische Strahlung zu einer Tertiärstrahlung mit einer Dominanzwellenlänge zu verschieben. Zudem ist das erste Konversionselement ausgebildet, um eine Sekundärstrahlung zu erzeugen, die eine kleinere Peakwellenlänge als die Tertiärstrahlung aufweist.

Bevorzugt sind genau ein erstes Konversionselement und ein zweites Konversionselement und keine weiteren Konversionselemente vorhanden. Als Lichtquelle dient bevorzugt einzig der eine oder die mehreren Halbleiterchips.

Da das erste Konversionselement ausgebildet ist, um eine Sekundärstrahlung zu erzeugen, die eine kleinere Peakwellenlänge als die Dominanzwellenlänge der Tertiärstrahlung aufweist, wird eine effiziente Farberzeugung ermöglicht. Zudem kann dadurch ein großer Farbraum (Gamut) mit einem relativ einfach aufgebauten Halbleiterbauelement erreicht werden.

Weiterhin kann mithilfe der Quantenstruktur, insbesondere verglichen zu Konversionselementen mit Leuchtstoffen, eine spektral schmalbandige Emission, beispielsweise mit einer vollen Halbwertsbreite (Full Width at Half Maximum, FWHM) von kleiner 50 nm, insbesondere im Bereich von 30 nm erzielt werden, während Leuchtstoffe typischerweise eine Abstrahlung mit einer vollen Halbwertsbreite zwischen etwa 50 und 100 nm bewirken. Dadurch kann eine höhere Farbreinheit erzielt werden, wodurch ein hoher Gamut mit hoher Effizienz erzielbar ist.

Gemäß zumindest einer Ausführungsform weisen die Primärstrahlung und/oder die Sekundärstrahlung eine volle Halbwertsbreite (FWHM) von mindestens 15 nm oder 20 nm oder 25 nm auf. Alternativ oder zusätzlich liegt diese volle Halbwertsbreite der Primärstrahlung und/oder der Sekundärstrahlung bei höchstens 50 nm oder 40 nm oder 30 nm.

Gemäß zumindest einer Ausführungsform weist die Tertiärstrahlung eine volle Halbwertsbreite (FWHM) von mindestens 20 nm oder 30 nm oder 40 nm auf. Alternativ oder zusätzlich liegt diese volle Halbwertsbreite bei höchstens 80 nm oder 60 nm oder 45 nm. Es ist möglich, dass die volle Halbwertsbreite der Tertiärstrahlung mindestens 100 % oder 110 % und/oder höchstens 150 % oder 180 % der vollen Halbwertsbreite der Primärstrahlung und/oder der Sekundärstrahlung beträgt.

Konversionselemente mit einer Quantenstruktur können sich weiterhin durch eine geringe Schichtdicke auszeichnen. Während zweite Konversionselemente mit Leuchtstoffen typischerweise eine Schichtdicke von etwa 30 µm bis 300 µm aufweisen, kann mit einem ersten Konversionselement mit einer Quantenstruktur eine Schichtdicke von unter einem 1 µm, beispielsweise zwischen 100 nm und 1 µm, erzielt werden. Die im Betrieb entstehende Verlustwärme kann so effizienter abgeführt werden.

In einer Ausführungsform ist das zweite Konversionselement mit dem Leuchtstoff ausgebildet, um eine Tertiärstrahlung mit einem roten Spektralbereich mit einer Dominanzwellenlänge zwischen 590 nm und 640 nm zu erzeugen. Dadurch wird der zur Verfügung stehende Farbraum verbessert. Mit anderen Worten handelt es sich bei der Tertiärstrahlung bevorzugt um rotes Licht.

In einer Ausführungsform ist das zweite Konversionselement mit dem Leuchtstoff ausgebildet, um eine Tertiärstrahlung mit einer Dominanzwellenlänge zwischen 590 nm und 625 nm, insbesondere zwischen 595 nm und 610 nm, zu erzeugen. Dadurch wird der zur Verfügung stehende Farbraum weiter verbessert.

In einer Ausführungsform ist das zweite Konversionselement mit dem Leuchtstoff ausgebildet, um eine Tertiärstrahlung mit einer Dominanzwellenlänge zwischen 610 nm und 633 nm, insbesondere zwischen 617 nm und 624 nm zu erzeugen. Dadurch wird eine weitere Verbesserung des zur Verfügung stehenden Farbraumes erreicht.

In einer Ausführungsform weist der Leuchtstoff Eu²⁺ dotierte Nitride oder Mn⁴⁺ dotierte Fluoride auf. Mit diesen Leuchtstoffen kann ein effizientes Materialsystem für den gewünschten Farbraum bereitgestellt werden. Diese Materialien eignen sich besonders für die Erzeugung der gewünschten Tertiärstrahlung.

In einer Ausführungsform ist der Leuchtstoff aus folgender Gruppe gewählt:

(Ca,Sr)AlSiN₃:Eu²⁺,

Sr(Ca,Sr)Si₂Al₂N₆:Eu²⁺,

(Sr,Ca)AlSiN₃^{∗}Si₂N₂O:Eu²⁺,

(Ca,Ba,Sr)₂Si₅N₈:Eu²⁺,

(Sr,Ca)[LiAl₃N₄]:Eu²⁺,

(K,Na)₂(Si,Ti)F₆: Mn⁴⁺.

In einer weiteren Ausführung ist der Halbleiterchip ausgebildet, um eine Primärstrahlung mit einem blauen Spektralbereich mit einer Peakwellenlänge und/oder einer Dominanzwellenlänge von mindestens 380 nm oder 400 nm oder 420 nm oder 430 nm und/oder von höchstens 480 nm oder 460 nm zu erzeugen. Mit anderen Worten handelt es sich bei der Primärstrahlung bevorzugt um blaues Licht.

In einer weiteren Ausführung ist das erste Konversionselement ausgebildet, um eine Sekundärstrahlung mit einem grünen Spektralbereich mit einer Peakwellenlänge und/oder einer Dominanzwellenlänge zwischen 520 nm und 545 nm zu erzeugen. Mit anderen Worten handelt es sich bei der Sekundärstrahlung bevorzugt um grünes Licht.

Gemäß zumindest einer Ausführungsform umfasst die Quantenstruktur eine Mehrzahl von Quantenschichten, zwischen denen Barriereschichten angeordnet sind, sodass die Quantenschichten und die Barriereschichten sich alternierend abwechseln und eine Mehrfachquantentopf-Struktur bilden. Die Quantenstruktur kann aus solchen Quantenschichten und Barriereschichten bestehen. Die Quantenschichten können auch als Quantentöpfe oder Quantentröge bezeichnet werden und sind bevorzugt zweidimensionale Quantenstrukturen. Das heißt, eine Dicke der Quantenschichten ist dann sehr viel kleiner als laterale Ausdehnungen der Quantenschichten. Besonders bevorzugt ist die Quantenstruktur epitaktisch gewachsen, zum Beispiel auf einem lichtdurchlässigen Aufwachssubstrat wie Saphir. Die Quantenstruktur kann sich in dem Halbleiterbauelement noch an dem Aufwachssubstrat befinden. Insbesondere handelt es sich bei der Quantenstruktur nicht um Quantenpunkte. Quantenpunkte sind näherungsweise nulldimensional, im Gegensatz zu den zweidimensionalen Quantenschichten.

Gemäß zumindest einer Ausführungsform umfasst die Quantenstruktur mindestens 5 oder 10 oder 20 und/oder höchstens 200 oder 100 oder 50 der Quantenschichten. Alternativ oder zusätzlich liegt eine Dicke der Quantenschichten bei mindestens 1,5 nm oder 2 nm oder 2,5 nm und/oder bei höchstens 6 nm oder 4 nm oder 3,5 nm. Die gleichen Werte können für die Barriereschichten gelten. Dabei basieren die Quantenschichten bevorzugt auf dem Materialsystem InₓGa₁₋ₓN. Für den Indiumgehalt gilt zum Beispiel 0,2 ≤ x oder 0,25 ≤ x und/oder x ≤ 0,4 oder x ≤ 0,35. Die Barriereschichten können aus Al_{y}Ga_{1-y}N oder GaN sein, wobei zum Beispiel 0,05 ≤ y oder 0,1 ≤ y und/oder y ≤ 0,5 oder y ≤ 0,4 gilt.

Gemäß zumindest einer Ausführungsform befindet sich das zweite Konversionselement zwischen dem Halbleiterchip und dem ersten Konversionselement. Dabei kann das zweite Konversionselement den Halbleiterchip berühren oder von dem Halbleiterchip beabstandet sein.

In einer weiteren Ausführung ist das erste Konversionselement auf dem Halbleiterchip angeordnet, und wobei das zweite Konversionselement auf dem ersten Konversionselement angeordnet ist, wobei das erste Konversionselement einen transparenten Träger aufweist, wobei die Quantenstruktur auf einer Unterseite des Trägers angeordnet ist, wobei die Unterseite dem Halbleiterchip zugewandt ist, und wobei der Träger insbesondere aus Saphir besteht. Die genannten Komponenten können direkt aufeinander folgen und sich somit berühren oder alternativ voneinander beabstandet sein.

In einer weiteren Ausführung weist der Träger auf einer Oberseite, die dem zweiten Konversionselement zugewandt ist, eine Bragg-Spiegelschicht auf.

In einer weiteren Ausführung ist das zweite Konversionselement auf dem Halbleiterchip angeordnet, und wobei das erste Konversionselement auf dem zweiten Konversionselement angeordnet ist, wobei das erste Konversionselement einen transparenten Träger aufweist, wobei die Quantenstruktur auf einer Unterseite des Trägers angeordnet ist, wobei die Unterseite dem zweiten Konversionselement zugewandt ist, und wobei der Träger insbesondere aus Saphir besteht. Die genannten Komponenten können direkt aufeinander folgen und sich somit berühren oder alternativ voneinander beabstandet sein.

In einer weiteren Ausführung weist der Träger auf einer Oberseite eine zweite Quantenstruktur auf. Dadurch wird der Anteil an Sekundärstrahlung erhöht. Die beiden Quantenstrukturen können gleich oder voneinander verschieden ausgebildet sein.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung der Ausführungsbeispiele, die im Zusammenhang mit den Zeichnungen näher erläutert werden, wobei
Figur 1 ein Vergleichsbeispiel eines Halbleiterbauelementes,
Figur 2 ein anderes Vergleichsbeispiel eines Halbleiterbauelementes,
Figur 3 ein weiteres Vergleichsbeispiel eines Halbleiterbauelementes,
Figur 4 eine Ausführungsform eines Halbleiterbauelementes,
Figur 5 eine weitere Ausführungsform eines Halbleiterbauelementes,
Figur 6 eine schematische Draufsicht auf ein Vergleichsbeispiel eines Halbleiterbauelementes,
Figur 7 ein erstes Diagramm einer Strahlungsintensität über die Wellenlänge einer Ausführungsform,
Figur 8 ein zweites Diagramm einer Strahlungsintensität über die Wellenlänge eines anderen Halbleiterbauelementes, und

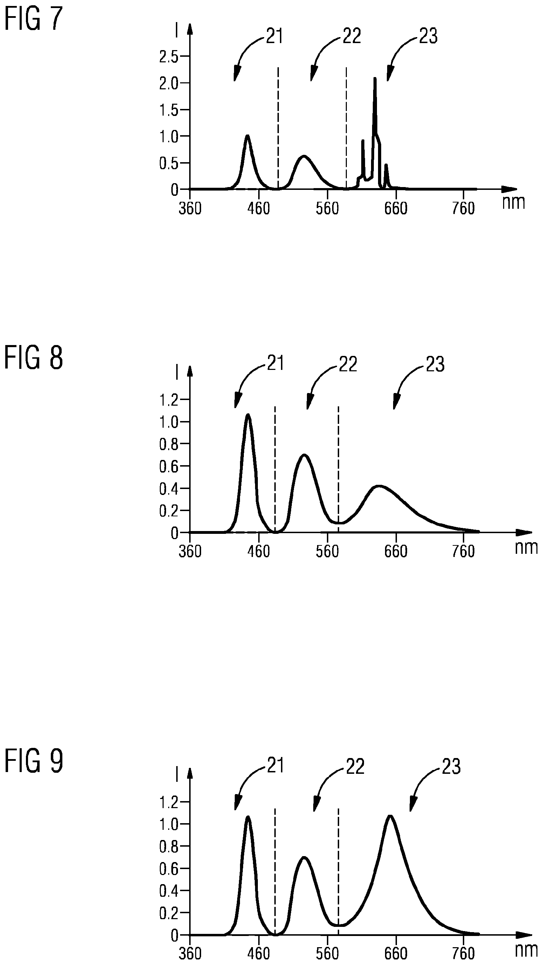

Figur 9 ein drittes Diagramm einer Strahlungsintensität über die Wellenlänge eines weiteren Halbleiterbauelementes zeigt. Das Halbleiterbauelement weist einen zur Erzeugung einer Primärstrahlung mit einer ersten Peakwellenlänge vorgesehenen Halbleiterchip und ein erstes Konversionselement mit einer Quantenstruktur auf, die über dem Halbleiterchip angeordnet ist. Das Halbleiterbauelement weist zudem ein zweites Konversionselement zur Erzeugung einer elektromagnetischen Tertiärstrahlung mit einer Dominanzwellenlänge auf. Weiterhin weist das erste Konversionselement in einer Ausführungsform ein für die Primärstrahlung und die Sekundärstrahlung durchlässiges Substrat auf, das beispielsweise aus Saphir besteht. Die Quantenstruktur ist auf dem Substrat angeordnet oder in dem Substrat integriert.

Die zweite Peakwellenlänge ist größer als die erste Peakwellenlänge. Zum Beispiel liegt die zweite Peakwellenlänge im grünen Spektralbereich und die Dominanzwellenlänge der Tertiärstrahlung liegt im roten oder gelben Spektralbereich. Beispielsweise liegt die erste Peakwellenlänge im blauen Spektralbereich.

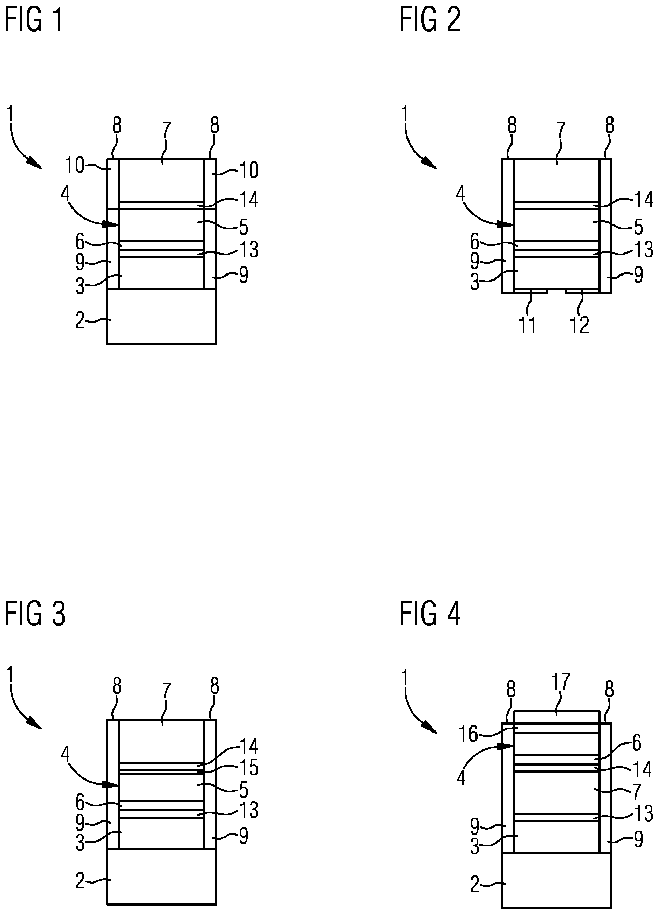

Figur 1 zeigt in einer schematischen Darstellung ein Beispiel eines Halbleiterbauelementes 1. Das Halbleiterbauelement 1 weist ein Substrat 2 auf, auf dem ein Halbleiterchip 3 angeordnet ist. Auf dem Halbleiterchip 3 ist ein erstes Konversionselement 4 angeordnet. Das erste Konversionselement 4 weist einen Träger 5 auf, auf dessen Unterseite eine Quantenstruktur 6 in Form einer Schicht aufgebracht ist. Die Quantenstruktur 6 ist einer Oberseite des Halbleiterchips zugewandt.

Die Bezeichnung Quantenstruktur umfasst im Rahmen der Anmeldung insbesondere jegliche Struktur, bei der Ladungsträger durch Einschluss eine Quantisierung ihrer Energiezustände erfahren können und deshalb eine einfallende elektromagnetische Primärstrahlung wenigstens teilweise in der Wellenlänge zu einer Sekundärstrahlung mit einer zweiten Peakwellenlänge gewandelt wird. Insbesondere beinhaltet die Bezeichnung Quantenstruktur keine Angabe über die Dimensionalität der Quantisierung. Sie umfasst somit unter anderem Quantentöpfe, Quantendrähte und Quantenpunkte und jede Kombination dieser Strukturen.

Besonders bevorzugt weist die Quantenstruktur eine Mehrzahl von Quantenschichten auf, zwischen denen Barriereschichten angeordnet sind. Zum Beispiel bilden die Quantenschichten und die Barriereschichten eine Mehrfachquantentopf-Struktur. Die Quantenschichten und die Barriereschichten erstrecken sich bevorzugt in gleichbleibender Zusammensetzung jeweils durchgehend über das erste Konversionselement 4 erstrecken.

Das erste Konversionselement 4 weist beispielsweise ein für die Primärstrahlung durchlässiges Substrat auf. Das Substrat dient insbesondere der mechanischen Stabilisierung der Quantenstruktur. Beispielsweise ist das Substrat mindestens fünfmal so dick wie die Quantenstruktur. Das Substrat kann ein Aufwachssubstrat für die beispielsweise epitaktische Abscheidung der Quantenstruktur sein. Somit kann die Quantenstruktur beispielsweise als epitaktisch abgeschiedene Halbleiterstruktur ausgebildet sein. Alternativ kann das Substrat auch von dem Aufwachssubstrat für die Quantenstruktur verschieden sein. Das Halbleiterbauelement kann auch mehr als ein solches erstes Konversionselement aufweisen. Beispielsweise können zwei oder mehr Quantenstrukturen insbesondere übereinander vorgesehen sein, die Strahlung mit derselben zweiten Peakwellenlänge emittieren. Die Effizienz der Strahlungskonversion kann so gesteigert werden.

Gemäß zumindest einer Ausführungsform des Halbleiterbauelements enthält die Quantenstruktur AlₓIn_{y}Ga_{1-x-y}N, AlₓIn_{y}Ga_{1-x-y}P oder AlₓIn_{y}Ga_{1-x-y}As. Hierbei gilt jeweils 0 ≤ x ≤ 1, 0 ≤ y ≤ 1 und x + y < 1. Mit diesen Materialien kann Strahlung im grünen, gelben oder roten Spektralbereich effizient erzeugt werden. Grundsätzlich eignet sich für die Quantenstruktur jedes Halbleitermaterial, dessen Bandlücke für die Erzeugung von Sekundärstrahlung mit der zu erzeugenden zweiten Peakwellenlänge geeignet ist.

Abhängig von der gewählten Ausführungsform kann das erste Konversionselement 4 mithilfe eines optisch transparenten Klebers mit dem Halbleiterchip 3 verbunden sein. Der Träger 5 besteht aus einem für die Primärstrahlung und/oder die Sekundärstrahlung optisch transparenten Material, insbesondere aus Saphir.

Auf dem ersten Konversionselement 4 ist ein zweites Konversionselement 7 angeordnet. Das zweite Konversionselement 7 ist abhängig von der gewählten Ausführungsform mithilfe eines optisch transparenten Klebers mit dem ersten Konversionselement 4 verbunden. Das zweite Konversionselement weist einen Leuchtstoff auf, wobei der Leuchtstoff ausgebildet ist, um eine elektromagnetische Strahlung, insbesondere die Primärstrahlung wenigstens teilweise zu einer Tertiärstrahlung mit einer Dominanzwellenlänge zu verschieben. Weiterhin kann abhängig von der gewählten Ausführungsform die Anordnung des Halbleiterchips 3, des ersten Konversionselementes 4 und des zweiten Konversionselementes 7 seitlich in eine Schutzschicht 8 eingebettet sein.

Bei dem Kleber kann es sich je um einen Silikonkleber handeln. Eine Dicke des Klebers liegt bevorzugt bei mindestens 0,2 µm oder 1 µm und/oder bei höchstens 10 µm oder 3 µm.

Abhängig von der gewählten Ausführungsform kann ein unterer Abschnitt 9 der Schutzschicht 8, der bis zu einer Oberseite des ersten Konversionselementes 4 reicht, als Reflexionsschicht für die elektromagnetische Strahlung, insbesondere mit Titanoxid ausgebildet sein. Weiterhin kann ein oberer Abschnitt 10 der Schutzschicht 8 in Form eines transparenten Materials wie beispielsweise Silikon ausgebildet sein.

Wie auch in allen anderen Ausführungsbeispielen können die gezeichneten Schichten direkt aufeinander folgen und sich berühren. Die dargestellten Flächen und Verbindungslinien sind bevorzugt eben und/oder gerade gestaltet, soweit nicht anders kenntlich gemacht. Weiterhin sind die dargestellten Flächen und Verbindungslinien entweder parallel oder senkrecht zueinander orientiert, wie es sich aus Figur 1 ergibt. Dies alles gilt bevorzugt auch für alle anderen Ausführungsbeispiele.

Figur 2 zeigt in einer schematischen Darstellung ein anderes Vergleichsbeispiel eines Halbleiterbauelementes 1, die im Wesentlichen gemäß der Fig. 1 ausgebildet ist, wobei jedoch der Halbleiterchip 3 in Form eines Dünnfilmhalbleiterchips ausgebildet ist, wobei der Halbleiterchip 3 in dieser Ausführungsform auf der Unterseite zwei Kontaktflächen 11, 12 aufweist.

Figur 3 zeigt ein weiteres Vergleichsbeispiel eines Halbleiterbauelementes 1, das im Wesentlichen gemäß der Ausführungsform der Figur 1 ausgebildet ist, wobei jedoch auf einer Oberseite des Trägers 5 eine dielektrische Schicht 15, insbesondere eine Bragg-Spiegelschicht, ausgebildet ist.

Figur 4 zeigt eine weitere Ausführungsform, bei der auf dem Substrat 2 der Halbleiterchip 3 angeordnet ist, wobei auf dem Halbleiterchip 3 ein zweites Konversionselement 7 angeordnet ist, das beispielsweise über eine erste Klebeschicht 13 mit dem Halbleiterchip 3 verbunden ist. Weiterhin ist auf dem zweiten Konversionselement 7 ein erstes Konversionselement 4 angeordnet. Abhängig von der gewählten Ausführungsform ist das erste Konversionselement 4 über eine zweite Klebeschicht 14 mit dem zweiten Konversionselement 7 verbunden.

Das erste Konversionselement 4 weist einen Träger 5 auf, auf dessen Unterseite eine Quantenstruktur 6 in Form einer Schicht ausgebildet ist. Zudem weist in dieser Ausführungsform das erste Konversionselement 4 auch auf einer Oberseite eine zweite flächige Quantenstruktur 16 auf. Zudem ist in dieser Ausführungsform eine Deckschicht 17 auf einer Oberseite des ersten Konversionselementes 4 angeordnet. Die Deckschicht 17 besteht aus einem transparenten Material, insbesondere aus transparentem Silikon. Die Deckschicht 17 stellt eine Schutzschicht dar und ist insbesondere für die Primärstrahlung, die Sekundärstrahlung und die Tertiärstrahlung transparent. Abhängig von der gewählten Ausführungsform kann auf die Deckschicht 17 verzichtet werden. Zudem kann auch abhängig von der gewählten Ausführungsform nur auf der Oberseite die zweite Quantenstruktur 16 vorgesehen sein und auf die Quantenstruktur 6 auf der Unterseite des Trägers 5 verzichtet werden.

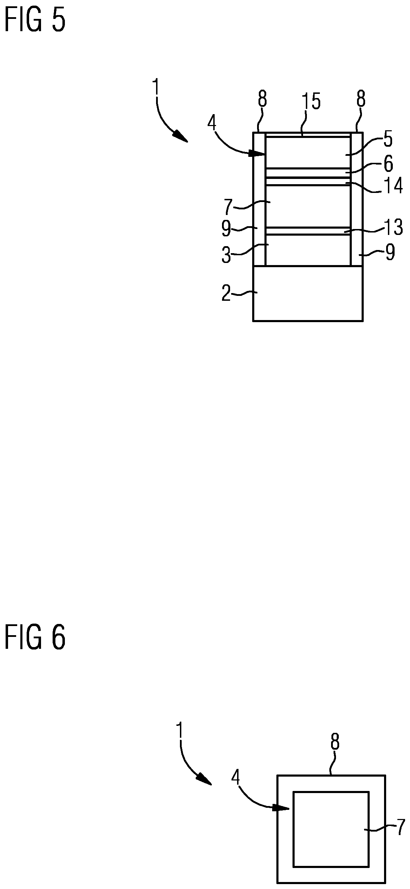

Figur 5 zeigt eine weitere Ausführungsform, die im Wesentlichen dem Aufbau der Figur 4 entspricht, wobei jedoch bei dieser Ausführungsform das erste Konversionselement 4 nur eine Quantenstruktur 6 auf einer Unterseite des Trägers 5 aufweist, die dem zweiten Konversionselement 7 zugewandt ist. Weiterhin ist bei dieser Ausführungsform auf einer Oberseite des Trägers 5 eine dielektrische Schicht 15, insbesondere eine Bragg-Spiegelschicht, ausgebildet. Abhängig von der gewählten Ausführungsform kann auf die Bragg-Spiegelschicht 15 verzichtet werden.

Figur 6 zeigt in einer schematischen Darstellung eine Ansicht von oben auf das Halbleiterbauelement gemäß Figur 1.

Der Halbleiterchip 3 der beschriebenen Ausführungsformen ist beispielsweise ausgebildet, um Licht mit einem Spektrum mit einer Peakwellenlänge zwischen 380 nm und 480 nm zu erzeugen. Die Quantenstruktur 6 und/oder die zweite Quantenstruktur 16 sind beispielsweise ausgebildet, um die vom Halbleiterchip 3 erzeugte Primärstrahlung in eine Sekundärstrahlung wenigstens teilweise zu wandeln, wobei die Sekundärstrahlung ein Spektrum aufweist, dessen Peakwellenlänge im Bereich zwischen 520 nm und 545 nm liegt.

Das zweite Konversionselement 7 der beschriebenen Ausführungsformen weist wenigstens einen oder mehrere Leuchtstoffe auf, die beispielsweise auf Nitrid oder Fluorid basieren.

Diese Leuchtstoffe können zum Beispiel aus folgendem Materialsystem bestehen: Eu²⁺ dotierte Nitride, beispielsweise (Ca,Sr)AlSiN₃:Eu²⁺, Sr(Ca,Sr)Si₂Al₂N₆:Eu²⁺, (Sr,Ca)AlSiN₃^{∗}Si₂N₂O:Eu²⁺, (Ca,Ba,Sr)₂Si₅N₈:Eu²⁺, (Sr,Ca)[LiA1₃N₄]:Eu²⁺. Weiterhin können die Leuchtstoffe aus folgendem Materialsystem bestehen: Mn⁴⁺ dotierte Fluoride, beispielsweise (K,Na)₂(Si,Ti)F₆:Mn⁴⁺. Die Dominanzwellenlängen der nitridischen Materialien befinden sich (Anregungswellenlänge = 460 nm) im Bereich von 590 nm bis 640 nm. Zudem können sich die Dominanzwellenlängen der nitridischen Materialien im Bereich von 595 nm bis 625 nm für die Materialsysteme (Ca,Sr)AlSiN₃:Eu²⁺, Sr(Ca,Sr)Si₂Al₂N₆:Eu²⁺, (Sr,Ca)AlSiN₃^{∗}Si₂N₂O:Eu²⁺ befinden. Zudem können sich die Dominanzwellenlängen der nitridischen Materialien im Bereich von 623 nm bis 633 nm für das Materialsystem (Sr,Ca)[LiAl₃N₄]:Eu²⁺ befinden. Weiterhin können sich die Dominanzwellenlängen der nitridischen Materialien im Bereich von 590 nm bis 610 nm für das Materialsystem (Ca,Ba,Sr)₂Si₅N₈:Eu²⁺ befinden. Die Farborte der nitridischen Leuchtstoffmaterialien liegen beispielsweise (Anregungswellenlänge = 460 nm) im Bereich von Cx = 0.595 - 0.625; Cy = 0.370 - 0.400 beziehungsweise im Bereich von Cx = 0.655 - 0.685; Cy = 0.300 - 0.350 beziehungsweise im Bereich von Cx = 0.620 - 0.655; Cy = 0.340 - 0.370 für die Materialsysteme (Ca,Sr)AlSiN₃:Eu²⁺, Sr(Ca,Sr)Si₂Al₂N₆:Eu²⁺, (Sr,Ca)AlSiN₃^{∗}Si₂N₂0:Eu²⁺.

Die Farborte liegen beispielsweise (Anregungswellenlänge = 460 nm) im Bereich von Cx = 0.680 - 0.715; Cy = 0.280 - 0.320 für das Materialsystem (Sr,Ca)[LiAl₃N₄]:Eu²⁺. Die Farborte liegen beispielsweise (Anregungswellenlänge = 460 nm) im Bereich von Cx = 0.610 - 0.650; Cy = 0.340 - 0.380 für das Materialsystem (Ca,Ba,Sr)₂Si₅N₈:Eu²⁺. Die Dominanzwellenlänge des fluoridischen Leuchtstoffmaterials befindet sich beispielsweise (Anregungswellenlänge = 460 nm) im Bereich von 610 - 630 nm. Die Dominanzwellenlänge des fluoridischen Leuchtstoffmaterials befindet sich zudem beispielsweise im Bereich von 617 - 624 nm. Der Farbort des fluoridischen Leuchtstoffmaterials liegt beispielsweise (Anregungswellenlänge = 460 nm) im Bereich von Cx = 0.680 - 0.710; Cy = 0.290 - 0.330. Die genannten Cx- und Cy-Werte beziehen sich bevorzugt auf die CIE-Normfarbtafel von 1931 und gelten bevorzugt auch in allen anderen Ausführungsbeispielen.

Figur 7 zeigt in einer schematischen Darstellung eine Strahlungsintensität I eines ersten Halbleiterbauelementes über die Wellenlänge in Nanometern (nm) aufgetragen. In einem ersten Abschnitt 21 des Wellenlängenspektrums ist der blaue Anteil, in einem zweiten Abschnitt 22 der grüne Anteil und in einem dritten Abschnitt 23 des Wellenlängenspektrums der rote Anteil der elektromagnetischen Strahlung eines Halbleiterbauelementes dargestellt. Dabei handelt es sich um ein Halbleiterbauelement mit einem Halbleiterchip 3, der blaues Licht erzeugt, wobei die Quantenstruktur 6 und/oder die zweite Quantenstruktur 16 das blaue Licht wenigstens teilweise in grünes Licht konvertiert, und wobei das zweite Konversionselement zum Beispiel K₂SiF₆:Mn⁴⁺ als Leuchtstoff aufweist und einen Teil der Primärstrahlung in eine Tertiärstrahlung mit rotem Licht umwandelt.

Figur 8 zeigt ein Diagramm für eine Intensität I eines Halbleiterbauelementes über die Wellenlänge in Nanometern aufgetragen. In einem ersten Abschnitt 21 des Wellenlängenspektrums ist der blaue Anteil, in einem zweiten Abschnitt 22 der grüne Anteil und in einem dritten Abschnitt 23 des Wellenlängenspektrums der rote Anteil der elektromagnetischen Strahlung eines Halbleiterbauelementes dargestellt. Das Halbleiterbauelement weist einen Halbleiterchip 3 auf, der als Primärstrahlung blaues Licht erzeugt, wobei die Quantenstruktur 6 und/oder die zweite Quantenstruktur 16 ausgebildet sind, um einen Teil der vom Halbleiterchip 3 erzeugten elektromagnetischen Primärstrahlung in grünes Licht als Sekundärstrahlung umzuwandeln. Das zweite Konversionselement weist einen Leuchtstoff auf, der in diesem Fall aus Sr(Ca,Sr)Si₂Al₂N₆:Eu²⁺ besteht und einen Teil der Primärstrahlung in eine Tertiärstrahlung mit rotem Licht wandelt.

Figur 9 zeigt ein Diagramm für eine Intensität eines Halbleiterbauelementes über die Wellenlänge in Nanometern aufgetragen. In einem ersten Abschnitt 21 des Wellenlängenspektrums ist der blaue Anteil, in einem zweiten Abschnitt 22 der grüne Anteil und in einem dritten Abschnitt 23 des Wellenlängenspektrums der rote Anteil der elektromagnetischen Strahlung eines Halbleiterbauelementes dargestellt. Das Halbleiterbauelement weist einen Halbleiterchip 3 auf, der als Primärstrahlung blaues Licht erzeugt, wobei die Quantenstruktur 6 und/oder die zweite Quantenstruktur 16 einen Teil des blauen Lichtes in grünes Licht umwandelt. Das zweite Konversionselement weist den Leuchtstoff (Sr,Ca)[LiAl₃N₄]:Eu²⁺ auf, der wenigstens einen Teil der Primärstrahlung in rotes Licht wandelt.

Die Deckschicht 17 und/oder die Schutzschicht 8 können in Form einer Streuschicht ausgebildet sein. Die Streuschicht enthält beispielsweise Streupartikel mit einer Konzentration zwischen 10 Gew% und einschließlich 30 Gew%. Die Schichtdicke der Streuschicht kann zwischen 10 µm und 30 µm liegen. Als Streupartikel können beispielsweise Titandioxid, Aluminiumoxid oder Zirkoniumoxid verwendet werden, die in einem Trägermaterial wie beispielsweise Silikon eingebettet sind.

Das Halbleiterbauelement kann auf einem Leiterrahmen angeordnet sein, der in einen Gehäusekörper eingebettet ist. Die erste und die zweite Klebeschicht 13, 14 können ein Polymermaterial, beispielsweise Silikon, enthalten. Der Brechungsindex der Klebeschichten 13, 14 kann zwischen 1,5 und dem Brechungsindex des an die Klebeschicht angrenzenden Materials des Halbleiterchips liegen. Die Schutzschicht 8 kann in Form einer Reflexionsschicht ausgebildet sein.

Das Halbleiterbauelement 1 kann in Form eines oberflächenmontierbaren Halbleiterbauelementes ausgebildet sein. Zudem kann der Träger 5 auch aus Siliziumkarbid bestehen.

Das erste Konversionselement mit einer insbesondere epitaktisch gewachsenen Quantenstruktur kann sich durch eine hohe Temperaturstabilität auszeichnen. Beispielsweise kann im roten Spektralbereich oder im grünen Spektralbereich liegende Sekundärstrahlung die hohe Temperaturstabilität einer auf Nitrid-Verbindungshalbleitermaterial, insbesondere auf AlₓIn_{y}Ga_{1-x-y}N, basierenden Leuchtdiode aufweisen. Weiterhin ist bei einem solchen Strahlungskonversionselement die Emissionswellenlänge einfach einstellbar, insbesondere durch Variation der Schichtdicken und der Materialien der Quantenstruktur. Der Konversionsgrad ist mittels der Anzahl der Quantenschichten einfach und zuverlässig einstellbar. Alternativ zu einer epitaktischen Abscheidung ist auch ein anderes Abscheideverfahren denkbar, beispielsweise Sputtern. Photolumineszente Strukturen können so besonders kostengünstig hergestellt werden.

Ferner hat sich gezeigt, dass die optische Anregung einer im grünen Spektralbereich emittierenden Quantenstruktur, beispielsweise auf der Basis von AlₓIn_{y}Ga_{1-x-y}N, effizienter ist als eine direkte Strahlungserzeugung in einer solchen Quantenstruktur durch elektrische Anregung.

Die von der Quantenstruktur abgewandte Seite des Trägers kann weiterhin zusätzliche optische Funktionen erfüllen, beispielsweise die Funktion eines insbesondere wellenlängenselektiven Spiegels oder Filters, und/oder die Funktion einer Auskoppelstruktur, beispielsweise einer Aufrauung.

Streuende Schichten oder Strukturen des Halbleiterbauelements bewirken weiterhin eine effiziente Farbmischung. Mittels einer dielektrischen Beschichtung insbesondere in Form eines Bragg-Spiegels kann beispielsweise eine wellenlängenselektive Auskopplung und/oder die Ausbildung einer resonanten Kavität für die erzeugte Strahlung und/oder eine Vorfilterung des Spektrums des Halbleiterbauelements auf einfache und zuverlässige Weise erzielt werden.

Die Quantenstruktur 6, 16 kann Quantenschichten umfassen, zwischen denen Barriereschichten angeordnet sind. Die Quantenschichten und Barriereschichten bilden eine Mehrfachquantentopfstruktur. In derartigen Quantenstrukturen findet innerhalb der Quantenschichten entlang genau einer Raumrichtung eine Quantisierung statt. Solche Quantenstrukturen sind besonders zuverlässig herstellbar und zeichnen sich durch eine hohe Effizienz aus. Die Anzahl der Quantenschichten kann in weiten Grenzen variiert werden. Beispielsweise weisen die Quantenstrukturen 6, 16 zwischen 2 und 100, beispielsweise 50 Quantenschichten, auf, die jeweils über Barriereschichten voneinander getrennt sind. Eine Schichtdicke der Quantenschicht beträgt vorzugsweise zwischen 1 nm und 10 nm. Eine Schichtdicke der Barriereschichten beträgt vorzugsweise zwischen 3 nm und 100 nm, beispielsweise 15 nm. Die Barriereschichten sind vorzugsweise nominell undotiert ausgebildet.

Für die Erzeugung grüner Sekundärstrahlung weisen die Quantenschichten vorzugsweise AlₓIn_{y}Ga_{1-x-y}N auf. Durch Erhöhung des Indium-Anteils und/oder eine Verbreiterung der Quantenschichten kann die Peakwellenlänge der Sekundärstrahlung erhöht werden. Durch weitere Erhöhung des Indium-Anteils kann auch Sekundärstrahlung mit einer Peakwellenlänge im gelben oder roten Spektralbereich erzielt werden. Für Sekundärstrahlung im roten Spektralbereich eignet sich weiterhin auch das Materialsystem AlₓIn_{y}Ga_{1-x-y}P.

Für Peakwellenlängen größer oder gleich 440 nm sind die Quantenschichten vorzugsweise frei von Aluminium oder im Wesentlichen frei von Aluminium, beispielsweise mit x ≤ 0,05. Weiterhin beträgt der Indiumgehalt y vorzugsweise etwa 50 %, beispielsweise zwischen einschließlich 0,45 und einschließlich 0,55, insbesondere zwischen einschließlich 0,44 und einschließlich 0,52. Derartige Materialien lassen sich mit hoher Kristallqualität auf Galliumarsenid epitaktisch abscheiden.

Das erste Konversionselement 4 weist einen Träger 5 auf. Der Träger 5 kann das Aufwachssubstrat für die epitaktische Abscheidung der Quantenstruktur 6, 16 sein. Insbesondere bei einem Aufwachssubstrat, das für die Primärstrahlung nicht strahlungsdurchlässig ist, beispielsweise bei Galliumarsenid, kann die Quantenstruktur 6, 16 auch auf ein vom Aufwachssubstrat verschiedenes Substrat übertragen werden, beispielsweise auf ein Glassubstrat. In diesem Fall ist das Substrat also verschieden von einem Aufwachssubstrat für die Quantenstruktur und stabilisiert die Quantenstruktur mechanisch. Das Aufwachssubstrat ist hierfür nicht mehr erforderlich und kann entfernt werden, so dass das Strahlungskonversionselement frei von einem Aufwachssubstrat ist.

Die dielektrische Schicht 15 kann mehrschichtig mit einer Mehrzahl von Schichten ausgebildet sein, wobei sich benachbarte Schichten der dielektrischen Beschichtung bezüglich des Brechungsindizes voneinander unterscheiden. Die dielektrische Schicht 15 kann beispielsweise so ausgebildet sein, dass die Primärstrahlung zumindest teilweise in das erste Konversionselement 4 zurückreflektiert wird und die Sekundärstrahlung nahezu ungehindert austritt. Weiterhin kann mittels der dielektrischen Beschichtung 5 eine resonante Kavität für zumindest einen Strahlungsanteil, also für die Primärstrahlung und/oder die Sekundärstrahlung und/oder die Tertiärstrahlung gebildet sein. Die dielektrische Schicht 15 kann beispielsweise eine Mehrzahl von dielektrischen Schichten aufweisen, wobei aneinander angrenzende Schichten jeweils voneinander verschiedene Brechungsindizes aufweisen. Die dielektrische Schicht 15 weist beispielsweise eine wellenlängenselektive Transmission auf. Die Transmission ist also für einen Spektralbereich größer also für einen anderen Spektralbereich. Zum Beispiel ist die dielektrische Schicht 15 für zumindest einen Strahlungsanteil, beispielsweise die Primärstrahlung oder einen Teil der Primärstrahlung, reflektierend ausgebildet. Alternativ oder ergänzend kann das emittierte Spektrum mittels der dielektrischen Beschichtung vorgefiltert sein, beispielsweise im Hinblick auf spezifische Kundenanforderungen. Die dielektrische Schicht 15 kann als Bragg-Spiegelschicht ausgebildet sein.

Die beschriebenen Halbleiterbauelemente eignen sich insbesondere für die Hinterleuchtung von Anzeigevorrichtung, beispielsweise Flüssigkristalldisplays (LCDs). Jedoch können die Halbleiterbauelemente auch für jede andere Art von Beleuchtung eingesetzt werden.

Obwohl die Erfindung im Detail durch das bevorzugte Ausführungsbeispiel näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

Diese Patentanmeldung beansprucht die Priorität der deutschen Patentanmeldung 10 2015 119 817.7.

### Bezugszeichenliste

- 1: Halbleiterbauelement
- 2: Substrat
- 3: Halbleiterchip
- 4: erstes Konversionselement
- 5: Träger
- 6: Quantenstruktur
- 7: zweites Konversionselement
- 8: Schutzschicht
- 9: unterer Abschnitt der Schutzschicht
- 10: oberer Abschnitt der Schutzschicht
- 11: erste Kontaktfläche
- 12: zweite Kontaktfläche
- 13: erste Klebeschicht
- 14: zweite Klebeschicht
- 15: dielektrische Schicht
- 16: zweite Quantenstruktur
- 17: Deckschicht
- 21: erster Abschnitt des Wellenlängenspektrums
- 22: zweiter Abschnitt des Wellenlängenspektrums
- 23: dritter Abschnitt des Wellenlängenspektrums

## Patentansprüche

1. Halbleiterbauelement (1) mit
- einem Halbleiterchip zur Erzeugung einer elektromagnetischen Primärstrahlung, die blaues Licht ist, mit einer ersten Peakwellenlänge,
- mit einem ersten Konversionselement (4), das eine Quantenstruktur (6) aufweist und die Quantenstruktur (6) eine Mehrzahl von Quantenschichten umfasst, zwischen denen Barriereschichten angeordnet sind, sodass die Quantenschichten und die Barriereschichten eine Mehrfachquantentopf-Struktur bilden, wobei die Quantenstruktur (6, 16) ausgebildet ist, um die Primärstrahlung teilweise in eine Sekundärstrahlung mit einer zweiten Peakwellenlänge zu verschieben und die Sekundärstrahlung grünes Licht ist, und
- einem zweiten Konversionselement (7), das einen Leuchtstoff aufweist, wobei der Leuchtstoff ein Eu2+-dotiertes Nitrid oder ein Mn4+-dotiertes Fluorid aufweist und dazu ausgebildet ist, um eine elektromagnetische Strahlung zu einer Tertiärstrahlung mit einer Dominanzwellenlänge zu verschieben, wobei das erste Konversionselement (4) ausgebildet ist, um eine Sekundärstrahlung zu erzeugen, die eine kleinere Peakwellenlänge als die Dominanzwellenlänge der Tertiärstrahlung aufweist und die Tertiärstrahlung rotes Licht ist, wobei
- sich das zweite Konversionselement (7) zwischen dem Halbleiterchip (3) und dem ersten Konversionselement (4) befindet
- das zweite Konversionselement (7) auf dem Halbleiterchip (3) angeordnet ist,
- das erste Konversionselement (4) auf dem zweiten Konversionselement (7) angeordnet ist,
- das erste Konversionselement (4) einen transparenten Träger (5) aufweist, wobei die Quantenstruktur (6) auf einer Unterseite des Trägers angeordnet ist, und
- die Unterseite dem zweiten Konversionselement (7) zugewandt ist, und wobei der Träger (5) aus Saphir besteht.

2. Halbleiterbauelement nach dem vorhergehenden Anspruch,
wobei der Leuchtstoff ausgebildet ist, Tertiärstrahlung mit einer Dominanzwellenlänge zwischen 590 nm und 640 nm zu erzeugen.

3. Halbleiterbauelement nach Anspruch 2,
wobei der Leuchtstoff ausgebildet ist, Tertiärstrahlung mit einer Dominanzwellenlänge zwischen 595 nm und 610 nm zu erzeugen.

4. Halbleiterbauelement nach einem der Ansprüche 2 oder 3,
wobei der Leuchtstoff ausgebildet ist, Tertiärstrahlung mit einer Dominanzwellenlänge zwischen 617 nm und 624 nm zu erzeugen.

5. Halbleiterbauelemente nach einem der vorhergehenden Ansprüche,
wobei der Leuchtstoff (K,Na)2(Si,Ti)F6:Mn4+ ist.

6. Halbleiterbauelement nach einem der Ansprüche 1 bis 4, wobei der Leuchtstoff aus folgender Gruppe gewählt ist:
(Ca,Sr)AlSiN3:Eu2+,
Sr(Ca,Sr)Si2A12N6:Eu2+,
(Sr,Ca)AlSiN3^{∗}Si2N2O:Eu²⁺,
(Ca,Ba,Sr)2Si5N8:Eu2+,
(Sr,Ca) [LiA13N4] :Eu2+.

7. Halbleiterbauelement nach einem der vorhergehenden Ansprüche,
wobei der Halbleiterchip (3) ausgebildet ist, Primärstrahlung mit einer Peakwellenlänge zwischen 380 nm und 480 nm zu erzeugen.

8. Halbleiterbauelement nach einem der vorhergehenden Ansprüche, wobei das erste Konversionselement (4) ausgebildet ist, Sekundärstrahlung einer Peakwellenlänge zwischen 520 nm und 545 nm zu erzeugen.

9. Halbleiterbauelement nach einem der vorhergehenden Ansprüche,
wobei der Träger (5) auf einer Oberseite, die dem zweiten Konversionselement (7) zugewandt ist, eine Bragg-Spiegelschicht (15) aufweist.

10. Halbleiterbauelement nach einem der vorhergehenden Ansprüche, wobei der Träger (5) auf einer Oberseite eine zweite Quantenstruktur (16) aufweist.

11. Halbleiterbauelement nach einem der vorhergehenden Ansprüche, wobei wenigstens eine Oberseite des Halbleiterbauelementes (1) mit einer transparenten Deckschicht (17) aus Silikon bedeckt ist.

12. Halbleiterbauelement nach einem der vorhergehenden Ansprüche, wobei wenigstens ein Teil der Seitenflächen des Halbleiterbauelementes (1) mit einer reflektierenden Schutzschicht bedeckt ist.

## Claims

1. Semiconductor component (1) having
- a semiconductor chip for generating a primary electromagnetic radiation, which is blue light, with a first peak wavelength
- having a first conversion element (4) which has a quantum structure (6) and the quantum structure (6) comprises a plurality of quantum layers, between which barrier layers are arranged, so that the quantum layers and the barrier layers form a multiple quantum well structure, wherein the quantum structure (6, 16) is formed to partially shift the primary radiation to a secondary radiation having a second peak wavelength and the secondary radiation is green light, and
- a second conversion element (7) which has a luminescent material, wherein the luminescent material has an Eu²⁺-doped nitride or an Mn⁴⁺-doped fluoride and is formed to shift an electromagnetic radiation to a tertiary radiation having a dominant wavelength, wherein the first conversion element (4) is formed to generate a secondary radiation having a smaller peak wavelength than the dominant wavelength of the tertiary radiation and the tertiary radiation is red light, wherein
- the second conversion element (7) is located between the semiconductor chip (3) and the first conversion element (4)
- the second conversion element (7) is arranged on the semiconductor chip (3),
- the first conversion element (4) is arranged on the second conversion element (7),
- the first conversion element (4) has a transparent carrier (5), wherein the quantum structure (6) is arranged on an underside of the carrier, and
- the underside faces the second conversion element (7), and wherein the carrier (5)consists of sapphire.

2. Semiconductor component according to the preceding claim,
wherein the luminescent material is formed to generate tertiary radiation having a dominant wavelength between 590 nm and 640 nm.

3. Semiconductor component according to claim 2,
wherein the luminescent material is formed to generate tertiary radiation having a dominant wavelength between 595 nm and 610 nm.

4. Semiconductor component according to one of claims 2 or 3,
wherein the luminescent material is formed to generate tertiary radiation having a dominant wavelength between 617 nm and 624 nm.

5. Semiconductor component according to one of the preceding claims,
wherein the luminescent material is (K,Na)₂(Si,Ti)F₆:Mn⁴⁺.

6. Semiconductor component according to one of claims 1 to 4,
where the luminescent material is selected from the following group: (Ca,Sr)AlSiN₃:Eu²⁺, Sr (Ca, Sr) Si₂Al₂N₆:Eu²⁺, (Sr,Ca)AlSiN₃^{∗}Si₂N₂O:Eu²⁺, (Ca,Ba,Sr)₂Si₅N₈:Eu²⁺, (Sr,Ca) [LiAl₃N₄]:Eu²⁺.

7. Semiconductor component according to one of the preceding claims,
wherein the semiconductor chip (3) is formed to generate primary radiation having a peak wavelength between 380 nm and 480 nm.

8. Semiconductor component according to one of the preceding claims, wherein the first conversion element (4) is formed to generate secondary radiation having a peak wavelength between 520 nm and 545 nm.

9. Semiconductor component according to one of the preceding claims,
wherein the carrier (5) has a Bragg mirror layer (15) on an upper side facing the second conversion element (7).

10. Semiconductor component according to one of the preceding claims, wherein the carrier (5) has a second quantum structure (16) on an upper side.

11. Semiconductor component according to one of the preceding claims, wherein at least one upper side of the semiconductor component (1) is covered with a transparent cover layer (17) made of silicone.

12. Semiconductor component according to one of the preceding claims, wherein at least a part of the side surfaces of the semiconductor component (1) is covered with a reflective protective layer.

## Revendications

1. Composant semi-conducteur (1) avec
- une puce semi-conductrice pour générer un rayonnement électromagnétique primaire, qui est de la lumière bleue, avec une première longueur d'onde de crête,
- avec un premier élément de conversion (4) qui comprend une structure quantique (6) et la structure quantique (6) comprend une pluralité de couches quantiques entre lesquelles des couches barrières sont disposées de sorte que les couches quantiques et les couches barrières forment une structure à puits quantiques multiples, dans lequel la structure quantique (6, 16) est formée pour déplacer partiellement le rayonnement primaire vers un rayonnement secondaire avec une deuxième longueur d'onde de crête et le rayonnement secondaire est de la lumière verte, et
- un deuxième élément de conversion (7) qui a un matériau luminescent, dans lequel le matériau luminescent comprend un nitrure dopé Eu²⁺ ou un fluorure dopé Mn⁴⁺ et est formé pour déplacer un rayonnement électromagnétique vers un rayonnement tertiaire avec une longueur d'onde dominante, dans lequel le premier élément de conversion (4) est formé pour générer un rayonnement secondaire avec une longueur d'onde de crête plus petite que la longueur d'onde dominante du rayonnement tertiaire et le rayonnement tertiaire est de la lumière rouge, dans lequel
- le deuxième élément de conversion (7) est situé entre la puce semi-conductrice (3) et le premier élément de conversion (4)
- le deuxième élément de conversion (7) est disposé sur la puce semi-conductrice (3),
- le premier élément de conversion (4) est disposé sur le deuxième élément de conversion (7),
- le premier élément de conversion (4) comprend un support (5) transparent, dans lequel la structure quantique (6) est disposée sur une face inférieure du support, et
- la face inférieure fait face au deuxième élément de conversion (7), et dans lequel le support (5) est constitué de saphir.

2. Composant semi-conducteur selon la revendication précédente,
dans lequel le matériau luminescent est formé pour générer un rayonnement tertiaire avec une longueur d'onde dominante comprise entre 590 nm et 640 nm.

3. Composant semi-conducteur selon la revendication 2,
dans lequel le matériau luminescent est formé pour générer un rayonnement tertiaire avec une longueur d'onde dominante comprise entre 595 nm et 610 nm.

4. Composant semi-conducteur selon l'une des revendications 2 ou 3,
dans lequel le matériau luminescent est formé pour générer un rayonnement tertiaire avec une longueur d'onde dominante comprise entre 617 nm et 624 nm.

5. Composant semi-conducteur selon l'une des revendications précédentes,
dans lequel le matériau luminescent est (K,Na)₂(Si,Ti)F₆:Mn⁴⁺.

6. Composant semi-conducteur selon l'une des revendications 1 à 4,
où la matière luminescente est choisie dans le groupe suivant: (Ca,Sr)AlSiN₃:Eu²⁺, Sr(Ca,Sr)Si₂Al₂N₆:Eu²⁺, (Sr,Ca)AlSiN₃^{∗}Si₂N₂O:Eu²⁺, (Ca,Ba,Sr)₂Si₅N₈:Eu²⁺, (Sr,Ca) [LiAl₃N₄] : Eu²⁺.

7. Composant semi-conducteur selon l'une des revendications précédentes,
dans lequel la puce semi-conductrice (3) est formée pour générer un rayonnement primaire avec une longueur d'onde de crête comprise entre 380 nm et 480 nm.

8. Composant semi-conducteur selon l'une des revendications précédentes, dans lequel le premier élément de conversion (4) est formé pour générer un rayonnement secondaire avec une longueur d'onde de crête comprise entre 520 nm et 545 nm.

9. Composant semi-conducteur selon l'une des revendications précédentes,
dans lequel le support (5) comporte une couche de miroir de Bragg (15) sur une face supérieure tournée vers le deuxième élément de conversion (7).

10. Composant semi-conducteur selon l'une des revendications précédentes, dans lequel le support (5) a une deuxième structure quantique (16) sur un côté supérieur.

11. Composant semi-conducteur selon l'une des revendications précédentes, dans lequel au moins une face supérieure du composant semi-conducteur (1) est recouverte d'une couche de couverture transparente (17) en silicone.

12. Composant semi-conducteur selon l'une des revendications précédentes, dans lequel au moins une partie des surfaces latérales du composant semi-conducteur (1) est recouverte d'une couche de protection réfléchissante.
